# EUROPEAN PATENT SPECIFICATION

(11) **EP 3 798 163 B1**
(45) Date of publication and mention of the grant of the patent: **22.02.2023**
(21) Application number: 18919548.0
(22) Date of filing: 23.05.2018
(51) Int. Cl.: B65H 20/20, H05K 13/02, H05K 13/04, H05K 13/08

(54) **TAPE-FEEDING DEVICE AND TAPE-FEEDING METHOD**
BANDZUFÜHRUNGSVORRICHTUNG UND BANDZUFÜHRVERFAHREN
DISPOSITIF D'ALIMENTATION DE BANDE ET PROCÉDÉ D'ALIMENTATION DE BANDE

(43) Date of publication of application: 31.03.2021
(73) Proprietor: Fuji Corporation, Chiryu-shi, Aichi 472-8686 (JP)
(72) Inventor: ASAO Hidekazu, Chiryu-shi, Aichi 472-8686 (JP); HARA Akira, Chiryu-shi, Aichi 472-8686 (JP)
(74) Representative: Grünecker Patent- und Rechtsanwälte PartG mbB
(86) International application number: PCT/JP2018/019805
(87) International publication number: WO 2019/224934

(56) References cited:
- JP-A- 2001 127 489
- JP-A- 2010 287 698
- JP-A- 2011 155 051
- JP-A- 2014 011 315
- JP-A- 2017 157 654
- US-A1- 2010 181 361

## Description

### Technical Field

The present specification discloses techniques related to a tape feeding device and a tape feeding method.

### Background Art

An electronic component mounting device described in Patent Literature 1 includes a camera and a control device. The camera captures a storage section at a component pickup position. The control device recognizes a position of the storage section based on an image captured by the camera. When it is determined that the position of the storage section deviates from a position set in advance, the control device causes a tape to be fed at a pitch smaller than a feeding pitch of the tape. Specifically, the control device outputs a signal of a minimum pitch-feeding to a component supply unit when a distance (deviation) between the position of the storage section of the component and a pickup position is no less than a determination distance with a repair condition of the pitch-feeding being satisfied. As a result, the component supply unit feeds the tape at the minimum pitch and repairs the pitch-feeding.

Patent Literature 2 provides a further Tape-feeding Device according to the prior art.

### Patent Literature

Patent Literature 1: JP-A-2011-155051
Patent Literature 2: US-2010-181361

### Summary of the Invention

### Technical Problem

However, in an electronic component mounting device described in Patent Literature 1, when the pitch-feeding is repaired, the tape is fed at the minimum pitch (regulated pitch in advance). Therefore, the electronic component mounting device described in Patent Literature 1 needs to feed the tape multiple times at the minimum pitch to align the position of the storage section with the pickup position of the component. It is determined based on the image captured by the camera whether the position of the storage section matches the pickup position. As described above, in the electronic component mounting device described in Patent Literature 1, the control when repairing the pitch-feeding is complicated.

In view of such circumstances, the present specification discloses a tape feeding device and a tape feeding method capable of adjusting a deviation amount between an arrival position of the component, when the continuous feeding of a carrier tape being continuously pitch-fed at a predetermined pitch, is ended, and a pickup position.

### Solution to Problem

The invention is defined by the features of claims 1 and 4. Further embodiments are defined in the dependent claims.

The present specification discloses a tape feeding device that is applied to a tape feeder including a sprocket and a motor, and that includes a movement amount calculation section and a stop position adjustment section. The sprocket includes multiple tooth portions pitch-feeding a carrier tape accommodating a component by sequentially engaged with multiple feed holes provided in the carrier tape. The motor rotates the sprocket. The movement amount calculation section calculates a movement amount of the carrier tape moved during execution of continuous feeding continuously pitch-feeding the carrier tape at a predetermined pitch, in which the calculation is made based on the number of steps of the motor during execution of the continuous feeding. The stop position adjustment section adjusts the movement amount of the carrier tape which is less than the predetermined pitch so that the component is positioned at a pickup position of the component, in which the adjustment is made based on the movement amount calculated by the movement amount calculation section characterized in that the tape feeding device comprises a detection sensor configured to detect the number of steps of the motor by detecting one tooth portion present at a detection position, when one cavity of multiple cavities of carrier tape is positioned at a supply section of tape feeder, wherein the detection position is provided at a position separated by an angle in the circumferential direction from above the rotation center of the sprocket in the vertical direction.

In addition, the present specification discloses a tape feeding method that is applied to a tape feeder including a sprocket and a motor, and that includes a movement amount calculation step and a stop position adjustment step. The sprocket includes multiple tooth portions pitch-feeding a carrier tape accommodating a component by sequentially engaged with multiple feed holes provided in the carrier tape. The motor rotates the sprocket. In the movement amount calculation step, a movement amount of the carrier tape moved during execution of continuous feeding continuously pitch-feeding the carrier tape at a predetermined pitch is calculated based on the number of steps of the motor during execution of the continuous feeding. In the stop position adjustment step, the movement amount of the carrier tape which is less than the predetermined pitch is adjusted so that the component is positioned at a pickup position of the component, in which the adjustment is performed based on the movement amount calculated by the movement amount calculation step, characterized by: a detection step to detect one tooth portion present at a detection position as the number of steps of the motor by a detection sensor when one cavity of multiple cavities of carrier tape is positioned at a supply section of tape feeder, wherein the detection position is provided at a position separated by an angle in the circumferential direction from above the rotation center of the sprocket in the vertical direction.

### Advantageous Effect of the Invention

According to the tape feeding device described above, the movement amount calculation section and the stop position adjustment section are provided. Therefore, the tape feeding device described above can adjust the deviation amount between the arrival position of the component when the continuous feeding is ended and the pickup position. In addition, the tape feeding device described above calculates the movement amount of the carrier tape during execution of the continuous feeding based on the number of steps of the motor during execution of the continuous feeding and adjusts the movement amount of the carrier tape. Therefore, the tape feeding device described above can adjust the deviation amount without using an imaging means such as a camera and can simplify the control. The above description of the tape feeding device can be similarly applied to the tape feeding method.

### Brief Description of Drawings

[Fig. 1] It is a perspective view illustrating an example of tape feeder 20.
[Fig. 2] It is a plan view illustrating an example of carrier tape 80.
[Fig. 3] It is a side view illustrating a configuration example of driving device 30 and detection sensor 50 of tape feeder 20.
[Fig. 4] It is a side view illustrating a configuration example of angle sensor 40 and detection sensor 50 of tape feeder 20 when viewed from the direction opposite to the direction illustrated in Fig. 3.
[Fig. 5] It is a plan view illustrating an example of work table 70 on which tape feeder 20 is mounted.
[Fig. 6] It is a block diagram illustrating an example of a control block of tape feeding device 10.
[Fig. 7] It is a flowchart illustrating an example of a control flow by tape feeding device 10.
[Fig. 8A] It is a diagram illustrating an example of a relationship between an arrival position and pickup position PS1 of target component 90T when continuous feeding is ended.
[Fig. 8B] It is a diagram illustrating an example of the relationship between the arrival position and pickup position PS1 of target component 90T when the movement amount of carrier tape 80 is adjusted by stop position adjustment section 62.

### Description of Embodiments

### 1. Configuration Example of Tape Feeder 20

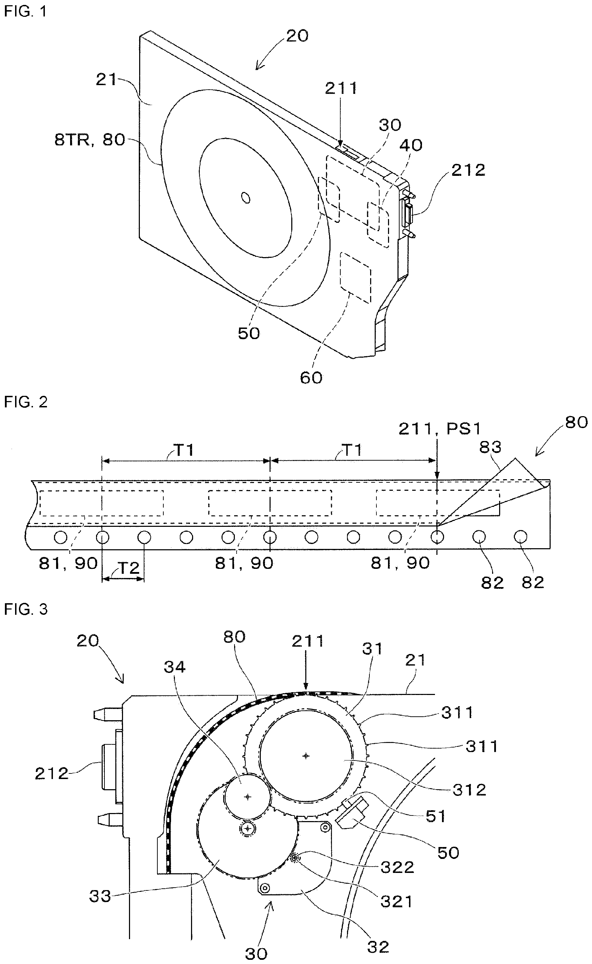

Tape feeding device 10 of the present embodiment is applied to tape feeder 20. As illustrated in Fig. 1, tape feeder 20 includes feeder main body 21, driving device 30, angle sensor 40, detection sensor 50, and control device 60.

Feeder main body 21 is formed in a flat box shape and is provided with supply section 211 supplying components to a component mounter (not illustrated). Supply section 211 is formed on an upper portion on a front portion side of feeder main body 21 (right side of drawing paper in drawing 1). In addition, feeder main body 21 detachably (exchangeably) holds tape reel 8TR around which carrier tape 80 is wound. Tape reel 8TR is rotatably supported by feeder main body 21. As illustrated in Fig. 2, carrier tape 80 is provided with multiple cavities 81, multiple feed holes 82, and cover tape 83. Each of multiple cavities 81 accommodates component 90. Multiple feed holes 82 are formed at predetermined intervals in a conveyance direction (longitudinal direction of carrier tape 80).

Cover tape 83 is bonded to an upper surface of carrier tape 80, and an opening section of each of multiple cavities 81 is closed. At a portion of carrier tape 80 conveyed to supply section 211, cover tape 83 is peeled off so that the component mounter can pick up component 90. That is, tape feeder 20 peels off cover tape 83 while conveying carrier tape 80 to sequentially position multiple cavities 81 in supply section 211. As a result, component 90 stored in cavity 81 positioned can be picked up by the component mounter.

Similarly to multiple feed holes 82, multiple cavities 81 are formed at predetermined intervals in the conveyance direction. Interval T1 of cavity 81 is appropriately set in accordance with the dimensions of component 90 to be accommodated. As illustrated in Fig. 2, in the present embodiment, interval T1 of cavity 81 is set to an integer multiple of interval T2 of feed hole 82 (four times in the same figure). In addition, interval T1 of cavity 81 may be set to the number obtained by multiplying interval T2 of feed hole 82 by an inverse of a predetermined integer (for example, the number obtained by multiplying interval T2 by 1/2).

As illustrated in Fig. 3, driving device 30 is provided with sprocket 31, motor 32, reduction gear 33, and intermediate gear 34. Sprocket 31 is rotatably supported by feeder main body 21 and is provided with multiple tooth portions 311. Multiple tooth portions 311 are formed along the circumferential direction of sprocket 31 at the same intervals as interval T2 of multiple feed holes 82 provided in carrier tape 80. Multiple tooth portions 311 sequentially engage with multiple feed holes 82 to pitch-feed carrier tape 80.

Motor 32 rotates sprocket 31. Motor 32 need only rotate sprocket 31 to convey carrier tape 80 and position component 90 accommodated in cavity 81 at supply section 211, which may take various aspects. As motor 32, for example, a known stepping motor, servo motor, or the like can be used.

When rotation shaft 321 of motor 32 rotates, reduction gear 33 that meshes with drive gear 322 provided on rotation shaft 321 rotates. Driving force of motor 32 is transmitted to sprocket 31 through intermediate gear 34 that meshes with reduction gear 33. Intermediate gear 34 meshes with sprocket gear 312 provided on sprocket 31, and sprocket 31 rotates with the rotation of intermediate gear 34.

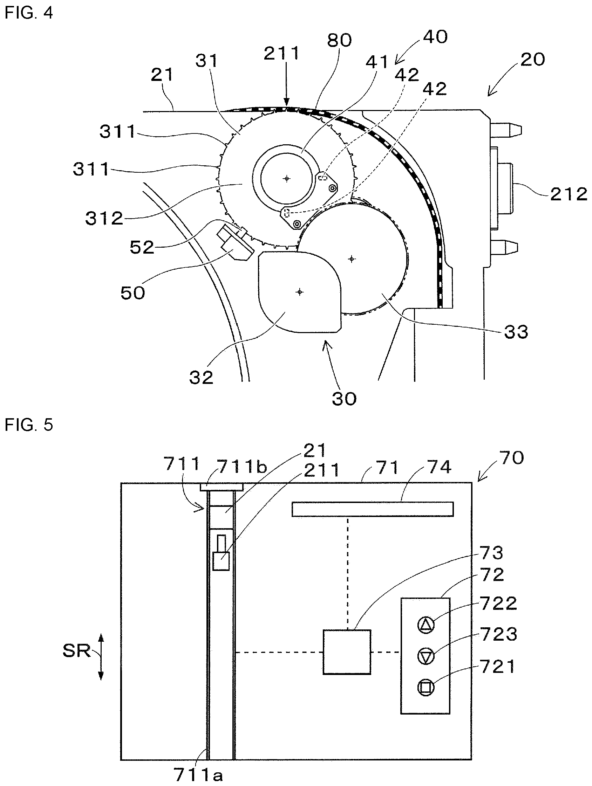

Angle sensor 40 detects an angle of sprocket 31 with respect to feeder main body 21. Angle sensor 40 need only be capable of detecting the angle, and may take various aspects. As angle sensor 40, for example, a known rotary encoder can be used. As illustrated in Fig. 4, in the present embodiment, angle sensor 40 is provided with magnet body 41 and a pair of magnetic sensors 42 and 42. Magnet body 41 is formed in a cylindrical shape and is magnetized to be bipolarized in the radial direction. Magnet body 41 is provided coaxially with sprocket 31 to rotate integrally with sprocket 31.

Each of the pair of magnetic sensors 42 and 42 detects the magnetic field formed by magnet body 41 and outputs a sinusoidal detection signal. The pair of magnetic sensors 42 and 42 are provided in feeder main body 21, spaced at intervals of 90 degrees along the circumferential direction of magnet body 41. As a result, the detection signals output by the pair of magnetic sensors 42 and 42 have a phase difference of 90 degrees. Angle sensor 40 calculates the angle of sprocket 31 provided with magnet body 41 based on the two detection signals detected by the pair of magnetic sensors 42 and 42.

Detection sensor 50 detects one tooth portion 311 of multiple tooth portions 311 of sprocket 31. In the present embodiment, detection sensor 50 is provided with light emitting section 51 and light receiving section 52. As illustrated in Figs. 3 and 4, light emitting section 51 and light receiving section 52 are disposed to face each other to grip tooth portion 311 at an outer edge section of sprocket 31. Detection sensor 50 receives the light irradiated from light emitting section 51 by light receiving section 52. Detection sensor 50 recognizes that one tooth portion 311 of multiple tooth portions 311 is positioned between light emitting section 51 and light receiving section 52 when a light receiving state of light receiving section 52 shifts to a light blocking state.

According to the invention, detection sensor 50 detects one tooth portion 311 present at a detection position when one cavity 81 of multiple cavities 81 of carrier tape 80 is positioned at supply section 211 of tape feeder 20. In the present embodiment, the detection position is provided at a position separated by 120 degrees in the circumferential direction from above the rotation center in the vertical direction. Detection sensor 50 needs only to be able to detect tooth portion 311, and may take various aspects. Detection sensor 50 can detect, for example, a reflected light reflected by tooth portion 311 to detect tooth portion 311 present at the detection position.

Control device 60 is provided with a central arithmetic unit, a first storage unit, a second storage unit, and an interface, which are electrically connected to each other via a bus (all not illustrated). The central arithmetic unit is a central processing unit (CPU) and can perform various arithmetic processing. The first storage unit is a volatile storage unit (random access memory: RAM) and can temporarily store various data in a state where power is supplied. As the first storage unit, for example, a known storage unit such as dynamic random access memory (DRAM), or static random access memory (SRAM) can be used.

The second storage unit is a non-volatile storage unit (read only memory: ROM) and can store various data even in a state where power is not supplied. For example, as the second storage unit, mask ROM in which the stored data cannot be rewritten can be used. In addition, the second storage unit may be a storage unit capable of rewriting stored data such as flash memory, electrically erasable programmable read only memory (EEPROM), or the like. The interface is a unit that electrically connects each unit of tape feeder 20 and control device 60, and for example, a communication interface, an input/output interface, or the like can be used. Control device 60 is electrically connected to each unit of tape feeder 20 via an interface, and it is possible to control each unit of tape feeder 20 while knowing the state of each unit of tape feeder 20.

When tape feeder 20 is mounted on the component mounter, power is supplied to control device 60 from the component mounter via connector 212. In addition, control device 60 may also communicate with the component mounter via connector 212. Control device 60 drives and controls driving device 30 based on a control command transmitted from the component mounter. Specifically, in a case where motor 32 of driving device 30 is a stepping motor, control device 60 transmits a pulse signal (drive signal) to motor 32. In a case where motor 32 of driving device 30 is a servo motor, control device 60 transmits a position command (drive signal) to motor 32. In either case, motor 32 drives based on the drive signal and sprocket 31 rotates, so that multiple cavities 81 of carrier tape 80 are sequentially positioned to supply section 211.

When the power of tape feeder 20 is turned on, control device 60 executes an origin alignment of sprocket 31. The origin alignment is to set an origin position for control. In the present embodiment, control device 60 drives motor 32 to rotate sprocket 31 to a predetermined angle at which detection sensor 50 detects one tooth portion 311 of multiple tooth portions 311. As a result, sprocket 31 is angled so that tooth portion 311 is positioned above the rotation center of sprocket 31 in the vertical direction, in which tooth portion 311 is separated, by 120 degrees in the circumferential direction, from another tooth portion 311 detected by detection sensor 50. Control device 60 can set the position of tooth portion 311 (for example, center) as the origin position. Tooth portion 311 detected by detection sensor 50 can also be specified based on the detection result (detection angle) of angle sensor 40. In this case, tape feeder 20 can start the conveyance of carrier tape 80 from predetermined tooth portion 311 (tooth portion 311 separated from specific tooth portion 311 by 120 degrees in the circumferential direction).

### 2. Configuration Example of Work Table 70

In work table 70, for example, before mounting tape feeder 20 to the component mounter, it is possible to perform heading work of component 90 in advance. In addition, in work table 70, for example, when tape feeder 20 is picked up from the component mounter, it is possible to perform such recovery work of rewinding carrier tape 80 to tape reel 8TR. As illustrated in Fig. 5, work table 70 includes main body section 71, operation section 72, control section 73, and display section 74. Main body section 71 is provided with fixed section 711 capable of mounting tape feeder 20. Guide groove 711a is formed in fixed section 711, and the operator slides tape feeder 20 in the sliding direction (arrow SR direction) along guide groove 711a to fix tape feeder 20 to fixed section 711. In addition, connector connection section 711b is formed in fixed section 711, and when tape feeder 20 and fixed section 711 are fixed to each other, connector 212 of tape feeder 20 and connector connection section 711b of work table 70 are connected to each other.

When tape feeder 20 is mounted on fixed section 711 of work table 70, the power is supplied to control device 60 of tape feeder 20 from work table 70 via connector 212. In addition, control device 60 may also communicate with work table 70 via connector 212. Control device 60 drives and controls driving device 30 based on a control command transmitted from work table 70. As described above, in the same manner as the case where tape feeder 20 is mounted on the component mounter, control device 60 can convey carrier tape 80.

Operation section 72 is provided with first instruction section 721, second instruction section 722, and third instruction section 723, which are operated by the operator. First instruction section 721 is operated in a case where the operator instructs the origin alignment. Second instruction section 722 is operated in a case where the operator instructs a feeding operation or a continuous feeding operation of carrier tape 80. Third instruction section 723 is operated in a case where the operator instructs a reverse feeding operation or a continuous reverse feeding operation of carrier tape 80. Similar to control device 60, control section 73 is provided with a central arithmetic unit, a first storage unit, a second storage unit, and an interface, which are electrically connected to each other via a bus (all not illustrated). Control section 73 is electrically connected to tape feeder 20 (control device 60), operation section 72, and display section 74 via the interface (in Fig. 5, connection state is illustrated by a broken line). Control section 73 transmits the above-described control command to control device 60 of tape feeder 20 based on an instruction from the operator via operation section 72.

When first instruction section 721 is operated by the operator (for example, operation button is pressed), control section 73 recognizes that the origin alignment is instructed by the operator. As described above, the origin alignment is to set the origin position for control. When recognizing that the origin alignment is instructed, control section 73 instructs control device 60 of tape feeder 20 to perform the origin alignment. As a result, in the same manner as the case where tape feeder 20 is mounted on the component mounter, control device 60 performs origin alignment.

When second instruction section 722 is operated by the operator (for example, the operation button is pressed), control section 73 recognizes that the operator instructs the feeding operation of carrier tape 80. The feeding operation refers to an operation of pitch-feeding carrier tape 80 at a pitch smaller than predetermined pitch PP1 (for example, pitch of half predetermined pitch PP1). When recognizing that the feeding operation is instructed, control section 73 instructs control device 60 of tape feeder 20 to perform the feeding operation. The feeding operation is executed every time second instruction section 722 is operated by the operator.

When second instruction section 722 is continuously operated for a predetermined time or longer by the operator (for example, the operation button is continuously pressed for a predetermined time or longer), control section 73 recognizes that the continuous feeding operation of carrier tape 80 is instructed by the operator. The continuous feeding operation refers to an operation of continuously pitch-feeding carrier tape 80 at predetermined pitch PP1. When recognizing that the continuous feeding operation is instructed, control section 73 instructs control device 60 of tape feeder 20 to perform the continuous feeding operation. The continuous feeding operation is executed while second instruction section 722 is operated by the operator, and is ended when the operation of second instruction section 722 is ended by the operator.

When third instruction section 723 is operated by the operator (for example, the operation button is pressed), control section 73 recognizes that the reverse feeding operation of carrier tape 80 is instructed by the operator. The reverse feeding operation refers to an operation of pitch-feeding carrier tape 80 at a pitch smaller than predetermined pitch PP1 (for example, pitch of half predetermined pitch PP1) in a direction opposite to a feeding direction of the feeding operation. When recognizing that the reverse feeding operation is instructed, control section 73 instructs control device 60 of tape feeder 20 to perform the reverse feeding operation. The reverse feeding operation is executed every time third instruction section 723 is operated by the operator.

When third instruction section 723 is continuously operated for a predetermined time or longer by the operator (for example, the operation button is continuously pressed for a predetermined time or longer), control section 73 recognizes that the continuous reverse feeding operation of carrier tape 80 is instructed by the operator. The continuous reverse feeding operation refers to an operation of continuously pitch-feeding carrier tape 80 at predetermined pitch PP1 in a direction opposite to the feeding direction of the feeding operation. When recognizing that the continuous reverse feeding operation is instructed, control section 73 instructs control device 60 of tape feeder 20 to perform the continuous reverse feeding operation. The continuous reverse feeding operation is executed while third instruction section 723 is operated by the operator, and is ended when the operation of third instruction section 723 is ended by the operator. For example, predetermined pitch PP1 described above can be set to an integer multiple of interval T1 of cavity 81 illustrated in Fig. 2 (one time in the present embodiment).

Display section 74 may display various information on work table 70 and tape feeder 20. For example, display section 74 can display an operation state of operation section 72 by the operator, a control state of tape feeder 20, a conveyance state of carrier tape 80, and the like on the display device (not illustrated). In addition, display section 74 can also be provided with both an input function and a display function. In this case, for example, as display section 74, a known touch panel or the like can be used, and display section 74 can include the function of operation section 72.

### 3. Control Example of Tape Feeding Device 10

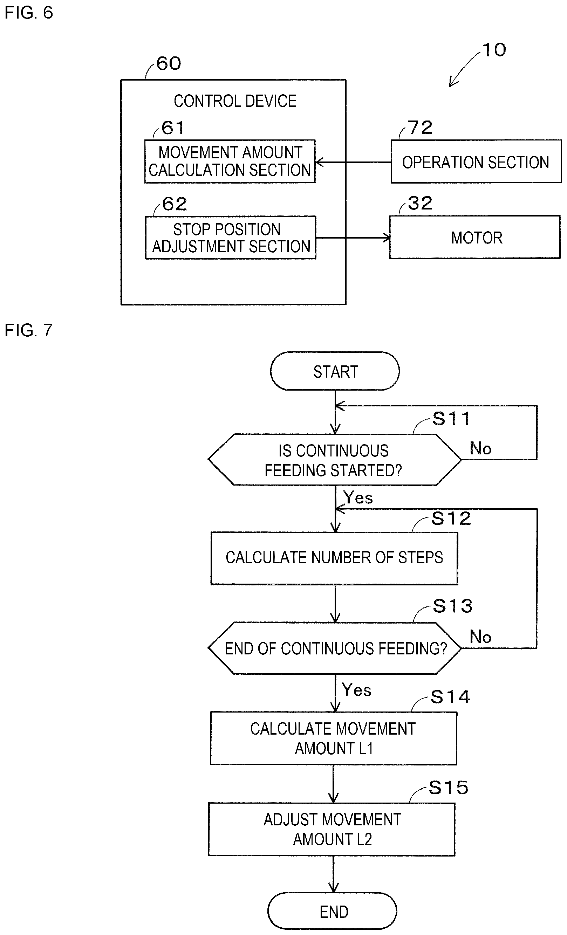

As illustrated in Fig. 6, tape feeding device 10 is provided with movement amount calculation section 61 and stop position adjustment section 62 when viewed as a control block. In the present embodiment, movement amount calculation section 61 and stop position adjustment section 62 is provided in control device 60. In addition, tape feeding device 10 executes control according to a flowchart illustrated in Fig. 7. Movement amount calculation section 61 performs determinations illustrated in Steps S11 and S13 and processing illustrated in Steps S12 and S14. Stop position adjustment section 62 performs processing illustrated in Step S15.

Tape feeding device 10 can perform the processing and the determinations illustrated in Steps S11 to S15 when the continuous feeding operation or the continuous reverse feeding operation of carrier tape 80 is performed. As described above, the continuous reverse feeding operation is the same as the continuous feeding operation except that the feeding direction is the opposite direction. Therefore, in the present specification, the description of the control when the continuous reverse feeding operation is performed is omitted. The matters described for the control when the continuous feeding operation is performed can be similarly applied to the control when the continuous reverse feeding operation is performed.

### 3-1. movement amount Calculation Section 61

Movement amount calculation section 61 calculates movement amount L1 of carrier tape 80 moved during execution of the continuous feeding continuously pitch-feeding carrier tape 80 at predetermined pitch PP1, in which the calculation is made based on the number of steps of motor 32 during the execution of the continuous feeding.

Specifically, movement amount calculation section 61 determines whether the continuous feeding of carrier tape 80 is started in Step S11 illustrated in Fig. 7. As described above, tape feeding device 10 of the present embodiment is provided with operation section 72 on work table 70, which allows the operator to instruct the continuous feeding. In addition, tape feeder 20 starts and ends the continuous feeding based on an instruction by the operator via operation section 72. Specifically, when second instruction section 722 is continuously operated for a predetermined time or longer by the operator, control section 73 recognizes that the continuous feeding operation of carrier tape 80 is instructed by the operator. When recognizing that the continuous feeding operation is instructed, control section 73 instructs control device 60 of tape feeder 20 to perform the start of the continuous feeding operation.

When instructed to start the continuous feeding operation from control section 73 (Yes in Step S11), control device 60 starts the continuous feeding of carrier tape 80. Movement amount calculation section 61 stores the number of steps of motor 32 during the execution of the continuous feeding in the first storage unit (volatile storage unit) described above (Step S12). As described above, motor 32 is a driving source for rotating sprocket 31, and for example, a known stepping motor, a servo motor, or the like can be used.

In a case where motor 32 is a stepping motor, the number of steps of motor 32 corresponds to the number of pulse signals to be transmitted to motor 32. Movement amount calculation section 61 stores the number of pulse signals to be transmitted to motor 32 during the execution of the continuous feeding. In a case where motor 32 is a servo motor, the number of steps of motor 32 corresponds to the difference of the position command to be transmitted to motor 32. Specifically, the number of steps of motor 32 can be calculated by subtracting the command position, when the continuous feeding is started, from the command position when the continuous feeding is ended. In a case where it is not instructed to start the continuous feeding operation from control section 73 (No in Step S11), the control returns to the determination illustrated in Step S11, and the movement amount calculation section 61 waits until it is instructed to start the continuous feeding operation from control section 73.

Next, movement amount calculation section 61 determines whether the continuous feeding of carrier tape 80 is to be ended (Step S13). As described above, the continuous feeding operation is executed while second instruction section 722 is operated by the operator, and is ended when the operation of second instruction section 722 is ended by operator. Control section 73 recognizes the end of continuous feeding operation when operation of second instruction section 722 is ended by the operator. When recognizing the end of the continuous feeding operation, control section 73 instructs control device 60 of tape feeder 20 to perform the end of the continuous feeding operation.

When it is instructed to end the continuous feeding operation from control section 73 (Yes in Step S13), control device 60 ends the continuous feeding of carrier tape 80. Movement amount calculation section 61 calculates movement amount L1 of carrier tape 80 moved during the execution of the continuous feeding (Step S14) based on the number of steps of motor 32 during the execution of the continuous feeding.

In a case where motor 32 is a stepping motor, movement amount L1 can be calculated by multiplying the number of steps of motor 32 (the number of pulse signals during the execution of the continuous feeding) by the step angle (angle at which sprocket 31 rotates in one pulse signal). In a case where motor 32 is a servo motor, movement amount L1 corresponds to the number of steps of motor 32 (difference in position command). In a case where the end of the continuous feeding operation is not instructed from control section 73 (NO in Step S13), the control returns to the processing illustrated in Step S12. Movement amount calculation section 61 continues to store the number of steps of motor 32 during the execution of the continuous feeding in the first storage unit until control section 73 instructs the end of the continuous feeding operation.

### 3-2. Stop Position Adjustment Section 62

Stop position adjustment section 62 adjusts movement amount L2 of carrier tape 80 which is less than predetermined pitch PP1 so that component 90 is positioned at pickup position PS1 of component 90 based on movement amount L1 calculated by movement amount calculation section 61 (Step S15 illustrated in Fig. 7). The control is temporarily ended. It is preferable that stop position adjustment section 62 adjusts movement amount L2 of less than predetermined pitch PP1 by feeding carrier tape 80 from end position PR1 where the continuous feeding is ended by deviation DE1 with respect to predetermined pitch PP1 obtained by subtracting predetermined surplus SU1 from predetermined pitch PP1. However, predetermined surplus SU1 is a surplus obtained by dividing movement amount L1 calculated by movement amount calculation section 61 by predetermined pitch PP1.

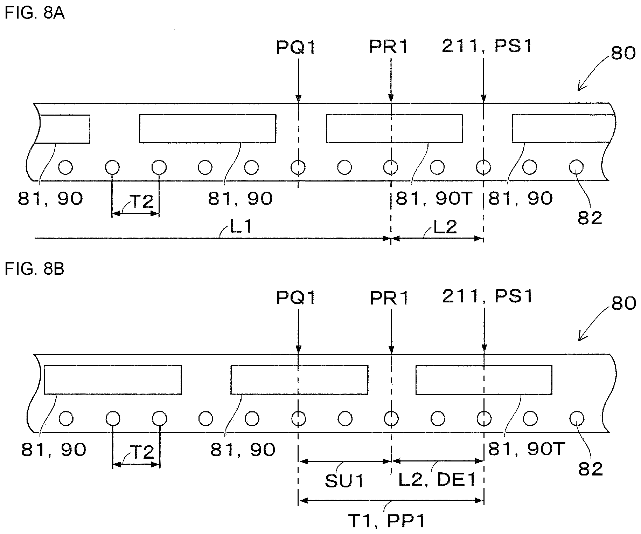

Fig. 8A illustrates an example of a relationship between the arrival position and pickup position PS1 of component 90 to be positioned (hereinafter referred to as target component 90T) when the continuous feeding is ended. In the same figure, the arrival position of target component 90T, when the continuous feeding is ended, is illustrated by end position PR1. The distance from the start position (not illustrated) of target component 90T when the continuous feeding is started to the arrival position (end position PR1) of target component 90T when the continuous feeding is ended corresponds to movement amount L1 of carrier tape 80 moved during the execution of the continuous feeding. In addition, the difference between pickup position PS1 of supply section 211 and arrival position PR1 of target component 90T (end position PR1) corresponds to movement amount L2 less than predetermined pitch PP1.

As described above, in the present embodiment, predetermined pitch PP1 is set to the same interval as interval T1 of cavity 81 illustrated in Fig. 2. In the example illustrated in Fig. 8A, movement amount L2 less than predetermined pitch PP1 is half interval T1 of cavity 81, which is twice interval T2 of feed hole 82. Stop position adjustment section 62 adjusts movement amount L2 of carrier tape 80 which is less than predetermined pitch PP1 so that component 90 (target component 90T) is positioned at pickup position PS1 of component 90 based on movement amount L1 calculated by movement amount calculation section 61. In the example illustrated in Fig. 8A, stop position adjustment section 62 uses motor 32 to feed carrier tape 80 from end position PR1 where the continuous feeding is ended by movement amount L2 less than predetermined pitch PP1.

Fig. 8B illustrates an example of the relationship between the arrival position and pickup position PS1 of target component 90T when the movement amount of carrier tape 80 is adjusted by stop position adjustment section 62. In the same figure, a position separated from pickup position PS1 by predetermined pitch PP1 (interval T1 of cavity 81) in the direction opposite to the feeding direction of carrier tape 80 is illustrated by reference position PQ1. The arrival position of target component 90T illustrated in Fig. 8A (end position PR1) is moved in the feeding direction of carrier tape 80 by predetermined surplus SU1 with respect to reference position PQ1. Predetermined surplus SU1 corresponds to a surplus obtained by dividing movement amount L1 calculated by movement amount calculation section 61 by predetermined pitch PP1 (interval T1 of cavity 81). In the example illustrated in the same figure, predetermined surplus SU1 is half interval T1 of cavity 81 and is twice interval T2 of feed hole 82.

As illustrated in Fig. 8B, the distance from end position PR1 where the continuous feeding is ended to pickup position PS1 corresponds to deviation DE1 amount with respect to predetermined pitch PP1 obtained by subtracting predetermined surplus SU1 from predetermined pitch PP1 (interval T1 of cavity 81). Therefore, by feeding carrier tape 80 from end position PR1 where the continuous feeding is ended by deviation DE1 with respect to predetermined pitch PP1, stop position adjustment section 62 can adjust movement amount L2 less than predetermined pitch PP1. As a result, tape feeding device 10 can adjust the deviation amount between the arrival position of component 90 (end position PR1), when the continuous feeding is ended, and pickup position PS1. In addition, when the continuous feeding is ended, the efficiency is improved as compared with the case where the operator operates second instruction section 722 to instruct the feeding operation (operation of pitch-feeding at a pitch smaller than predetermined pitch PP1).

### 4. Others

The embodiment described above is described by taking cassette type tape feeder 20 in which tape reel 8TR is covered by feeder main body 21 as an example. However, tape feeding device 10 can also be applied to a tape feeder in which tape reel 8TR is exposed from feeder main body 21. Since the tape feeder is less restricted in size as compared with cassette type tape feeder 20, the tape feeder can be provided with operation section 72.

### 5. Tape Feeding Method

The above description of tape feeding device 10 can be similarly applied to the tape feeding method. Specifically, the tape feeding method is applied to tape feeder 20 including sprocket 31 and motor 32, and is provided with a movement amount calculation step and a stop position adjustment step. The control performed by movement amount calculation section 61 corresponds to the movement amount calculation step. The control performed by stop position adjustment section 62 corresponds to the stop position adjustment step. Specifically, the movement amount calculation step is a step of calculating movement amount L1 of carrier tape 80 moved during the execution of the continuous feeding based on the number of steps of motor 32 during the execution of the continuous pitch-feeding in which carrier tape 80 is continuously pitch-fed at predetermined pitch PP1. The stop position adjustment step is a step of adjusting movement amount L2 of carrier tape 80 which is less than predetermined pitch PP1 so that component 90 is positioned at pickup position PS1 of component 90 based on movement amount L1 calculated by the movement amount calculation step.

In addition, the stop position adjustment step is preferably a step of adjusting movement amount L2 less than predetermined pitch PP1 by feeding carrier tape 80 from end position PR1 where the continuous feeding is ended by deviation DE1 with respect to predetermined pitch PP1, obtained by subtracting predetermined surplus SU1 from predetermined pitch PP1. However, predetermined surplus SU1 is a surplus obtained by dividing movement amount L1 calculated by the movement amount calculation step by predetermined pitch PP1.

### 6. Example of effects of embodiment

According to tape feeding device 10 is provided with movement amount calculation section 61 and stop position adjustment section 62. Therefore, tape feeding device 10 can adjust the deviation amount between the arrival position of component 90, when the continuous feeding is ended, and pickup position PS1. In addition, tape feeding device 10 calculates movement amount L1 of carrier tape 80 moved during the execution of continuous feeding based on the number of steps of motor 32 during the execution of the continuous feeding, and adjusts movement amount of carrier tape 80. Therefore, tape feeding device 10 can adjust the deviation amount without using imaging means such as a camera, and can simplify the control. The above description of tape feeding device 10 can be similarly applied to the tape feeding method.

### Reference Signs List

10: tape feeding device, 20: tape feeder, 31: sprocket, 311: tooth portion, 32: motor, 61: movement amount calculation section, 62: stop position adjustment section, 72: operation section, 80: carrier tape, 82: feed hole, 90: component, L1, L2: movement amount, PP1: predetermined pitch, SU1: predetermined surplus, DE1: deviation, PR1: end position, PS1: pickup position.

## Claims

1. A tape feeding device (10) applied to a tape feeder (20) including a sprocket (31) having multiple tooth portions (311) pitch-feeding a carrier tape (80) accommodating a component (90) by sequentially engaging with multiple feed holes (82) provided in the carrier tape (80), and a motor (32) rotating the sprocket (31), the device comprising:
a movement amount calculation section (61) configured to calculate a movement amount (L2) of the carrier tape (80) moved during execution of continuous feeding, continuously pitch-feeding the carrier tape (80) at a predetermined pitch (PP1), in which the calculation is made based on a number of steps of the motor (32) during execution of the continuous feeding; and
a stop position adjustment section (62) configured to adjust the movement amount (L2) of the carrier tape (80) which is less than the predetermined pitch (PP1) so that the component (90) is positioned at a pickup position (PS1) of the component (90), in which the adjustment is made based on the movement amount (L2) calculated by the movement amount calculation section (61),
**characterized in that:**
tape feeding device (10) comprises a detection sensor (50) configured to detect the number of steps of the motor (32) by detecting one tooth portion (311) present at a detection position, when one cavity (81) of multiple cavities (81) of carrier tape (80) is positioned at a supply section (211) of tape feeder (20),
wherein the detection position is provided at a position separated by an angle in the circumferential direction from above the rotation center of the sprocket (31) in the vertical direction.

2. The tape feeding device (10) according to claim 1, wherein,
when a surplus, which is obtained by dividing the movement amount (L2), being calculated by the movement amount calculation section (61), by the predetermined pitch (PP1), is defined as a predetermined surplus (SU1),
the stop position adjustment section (62) adjusts the movement amount (L2), which is less than the predetermined pitch (PP1), by feeding the carrier tape (80) from an end position (PR1) where the continuous feeding is ended by a deviation (DE1) with respect to the predetermined pitch (PP1) obtained by subtracting the predetermined surplus (SU1) from the predetermined pitch (PP1).

3. The tape feeding device (10) according to claim 1 or claim 2, further comprising:
an operation section (72) configured to instruct the continuous feeding by an operator, wherein
the tape feeder (20) starts and ends the continuous feeding based on an instruction from the operator via the operation section (72).

4. A tape feeding method applied to a tape feeder (20) including a sprocket (31) having multiple tooth portions (311) pitch-feeding a carrier tape (80) accommodating a component (90) by sequentially engaging with multiple feed holes (82) provided in the carrier tape (80), and a motor (32) rotating the sprocket (31), the method comprising:
a movement amount calculation step of calculating a movement amount (L2) of the carrier tape (80) moved during execution of continuous feeding, continuously pitch-feeding the carrier tape (80) at a predetermined pitch (PP1), in which the calculation is performed based on the number of steps of the motor (32) during execution of the continuous feeding; and
a stop position adjustment step of adjusting the movement amount (L2) of the carrier tape (80) which is less than the predetermined pitch (PP1) so that the component (90) is positioned at a pickup position (PS1) of the component (90), in which the adjustment is performed based on the movement amount (L2) calculated by the movement amount calculation step
**characterized by:**
a detection step to detect one tooth portion (311) present at a detection position as the number of steps of the motor (32) by a detection sensor (50) when one cavity (81) of multiple cavities (81) of carrier tape (80) is positioned at a supply section (211) of tape feeder (20),
wherein the detection position is provided at a position separated by an angle in the circumferential direction from above the rotation center of the sprocket (31) in the vertical direction.

## Patentansprüche

1. Eine Bandzuführungsvorrichtung (10), die auf einen Bandzuführer (20) angewendet wird, der ein Kettenrad (31) mit mehreren Zahnabschnitten (311), die ein Trägerband (80), das ein Bauteil (90) aufnimmt, durch aufeinanderfolgendes Eingreifen in mehrere Zuführungslöcher (82), die in dem Trägerband (80) angeordnet sind, im Abstand zuführen, und einen Motor (32), der das Kettenrad (31) dreht, umfasst, wobei die Vorrichtung Folgendes umfasst:
einen Bewegungsbetragsberechnungsabschnitt (61), der konfiguriert ist einen Bewegungsbetrag (L2) des Trägerbandes (80) zu berechnen, das während der Ausführung des kontinuierlichen Vorschubs bewegt wird, wobei das Trägerband (80) kontinuierlich mit einem vorbestimmten Abstand (PP1) vorgeschoben wird, wobei die Berechnung auf der Grundlage einer Anzahl von Schritten des Motors (32) während der Ausführung des kontinuierlichen Vorschubs durchgeführt wird; und
einen Stopppositions-Einstellabschnitt (62), der konfiguriert ist den Bewegungsbetrag (L2) des Trägerbandes (80), der kleiner als der vorbestimmte Abstand (PP1) ist, so einstellt, dass das Bauteil (90) an einer Aufnahmeposition (PS1) des Bauteils (90) positioniert wird, wobei die Einstellung auf der Grundlage des durch den Bewegungsbetragsberechnungsabschnitt (61) berechneten Bewegungsbetrags (L2) vorgenommen wird,
**gekennzeichnet dadurch dass:**
die Bandzuführungsvorrichtung (10) einen Erfassungssensor (50) umfasst, der konfiguriert ist die Anzahl der Schritte des Motors (32) zu erfassen, indem er einen Zahnabschnitt (311) erfasst, der an einer Erfassungsposition vorhanden ist, wenn ein Hohlraum (81) von mehreren Hohlräumen (81) des Trägerbandes (80) an einem Zuführungsabschnitt (211) der Bandzuführungsvorrichtung (20) positioniert ist, wobei die Erfassungsposition an einer Position angeordnet ist, die um einen Winkel in der Umfangsrichtung von in der vertikalen Richtung oberhalb des Rotationszentrums des Kettenrades (31) getrennt ist.

2. Die Bandzuführungsvorrichtung (10) gemäß Anspruch 1, wobei,
wenn ein Überschuss, der durch Dividieren des Bewegungsbetrags (L2), der durch den Bewegungsbetragsberechnungsabschnitt (61) berechnet wird, durch die vorbestimmte Teilung (PP1) erhalten wird, als ein vorbestimmter Überschuss (SU1) definiert ist,
der Stopppositions-Einstellabschnitt (62) den Bewegungsbetrag (L2) einstellt, der kleiner als die vorbestimmte Teilung (PP1) ist, indem das Trägerband (80) von einer Endposition (PR1) aus zugeführt wird, in der die kontinuierliche Zuführung durch eine Abweichung (DE1) in Bezug auf die vorbestimmte Teilung (PP1) beendet wird, die durch Subtrahieren des vorbestimmten Überschusses (SU1) von der vorbestimmten Teilung (PP1) erhalten wird.

3. Die Bandzuführungsvorrichtung (10) gemäß Anspruch 1 oder 2, des Weiteren umfassend:
einen Bedienabschnitt (72), der konfiguriert ist den kontinuierlichen Vorschub durch eine Bedienungsperson anzuweisen, wobei
der Bandzuführer (20) den kontinuierlichen Vorschub auf der Grundlage einer Anweisung von der Bedienungsperson über den Bedienungsabschnitt (72) beginnt und beendet.

4. Ein Bandzuführungsverfahren, das auf einem Bandzuführer (20) angewendet wird, der ein Kettenrad (31) mit mehreren Zahnabschnitten (311), die ein Trägerband (80), das ein Bauteil (90) aufnimmt, durch aufeinanderfolgendes Eingreifen in mehrere Zuführungslöcher (82), die in dem Trägerband (80) angeordnet sind, im Abstand zuführen, und einen Motor (32), der das Kettenrad (31) dreht, umfasst, wobei das Verfahren umfasst:
einen Bewegungsbetragsberechnungsschritt zum Berechnen eines Bewegungsbetrags (L2) des Trägerbandes (80), das während der Ausführung des kontinuierlichen Vorschubs bewegt wird, wobei das Trägerband (80) kontinuierlich mit einem vorbestimmten Abstand (PP1) vorgeschoben wird, wobei die Berechnung auf der Grundlage der Anzahl von Schritten des Motors (32) während der Ausführung des kontinuierlichen Vorschubs durchgeführt wird; und
einen Stopppositions-Einstellschritt zum Einstellen des Bewegungsbetrags (L2) des Trägerbands (80), der kleiner als der vorbestimmte Abstand (PP1) ist, so dass das Bauteil (90) an einer Aufnahmeposition (PS1) des Bauteils (90) positioniert wird, wobei die Einstellung auf der Grundlage des durch den Bewegungsbetragsberechnungsschritt berechneten Bewegungsbetrags (L2) durchgeführt wird
**gekennzeichnet durch:**
einen Erfassungsschritt zum Erfassen eines Zahnabschnitts (311), der an einer Erfassungsposition als die Anzahl der Schritte des Motors (32) durch einen Erfassungssensor (50) vorhanden ist, wenn ein Hohlraum (81) von mehreren Hohlräumen (81) des Trägerbandes (80) an einem Zuführungsabschnitt (211) der Bandzuführung (20) positioniert ist, wobei die Erfassungsposition an einer Position vorgesehen ist, die durch einen Winkel in der Umfangsrichtung von oberhalb des Rotationszentrums des Kettenrads (31) in der vertikalen Richtung getrennt ist.

## Revendications

1. Dispositif de chargement de bande (10) appliqué à un chargeur de bandes (20) incluant un pignon (31) présentant plusieurs parties dentées (311) faisant avancer par pas une bande porteuse (80) accueillant un composant (90) en entrant séquentiellement en contact avec plusieurs trous d'avancée (82) disposés sur la bande porteuse (80), et un moteur (32) faisant tourner le pignon (31), le dispositif comprenant :
une section de calcul de quantité de mouvement (61) configurée pour calculer une quantité de mouvement (L2) de la bande porteuse (80) déplacée au cours d'une exécution d'une avancée continue, faisant avancer continuellement par pas la bande porteuse (80) selon un pas prédéterminée (PP1), dans laquelle le calcul est effectué selon un nombre de pas du moteur (32) au cours d'une exécution de l'avancée continue ; et
une section d'ajustement de position d'arrêt (62) configurée pour ajuster la quantité de mouvement (L2) de la bande porteuse ((80) qui est inférieure au pas prédéterminé (PP1) de sorte que le composant (90) soit positionné sur une position de prélèvement (PS1) du composant (90), dans laquelle l'ajustement est effectué selon la quantité de mouvement (L2) calculée par la section de calcul de quantité de mouvement (61),
**caractérisé en ce que :**
le dispositif de chargement de bande (10) comprend un capteur de détection (50) configuré pour détecter le nombre de pas du moteur (32) en détectant une partie dentée (311) présente sur une position de détection, lorsqu'une cavité (81) de plusieurs cavités (81) de bande porteuse (80) est positionnée sur une section d'avancée (211) de chargeur de bandes (20),
dans lequel la position de détection est disposée sur une position séparée par un angle dans la direction circonférentielle depuis le dessus du centre de rotation du pignon (31) dans la direction verticale.

2. Le dispositif de chargement de bande (10) selon la revendication 1, dans lequel,
lorsqu'un surplus, qui est obtenu en divisant la quantité de mouvement (12), calculée par la section de calcul de quantité de mouvement (61), par le pas prédéterminé (PP1), est défini en tant que surplus prédéterminé (SU1),
la section d'ajustement de position d'arrêt (62) ajuste la quantité de mouvement (L2), qui est inférieure au pas prédéterminé (PP1), en faisant avancer la bande porteuse (80) depuis une position d'extrémité (PR1) où l'avancée continue est arrêtée par une déviation (DE1) par rapport au pas prédéterminé (PP1) obtenue en soustrayant le surplus prédéterminé (SU1) du pas prédéterminé (PP1).

3. Le dispositif de chargement de bande (10) selon la revendication 1 ou la revendication 2, comprenant en outre :
une section de fonctionnement (72) configurée pour permettre à un opérateur de commander l'avancée continue, dans lequel
le chargeur de bandes (20) initie et arrête l'avancée continue selon une instruction émanant de l'opérateur via la section de fonctionnement (72).

4. Procédé d'avancée de bande appliqué à un chargeur de bandes (20) incluant un pignon (31) présentant plusieurs parties dentées (311) faisant avancer par pas une bande porteuse (80) accueillant un composant (90) en entrant séquentiellement en contact avec plusieurs trous d'avancée (82) disposés sur la bande porteuse (80), et un moteur (32) faisant tourner le pignon (31), le procédé comprenant :
une étape de calcul de quantité de mouvement de calcul d'une quantité de mouvement (L2) de la bande porteuse (80) déplacée au cours d'une exécution d'une alimentation continue, faisant avancer continuellement par pas la bande porteuse (80) selon un pas prédéterminée (PP1), dans laquelle le calcul est effectué selon le nombre de pas du moteur (32) au cours d'une exécution de l'avancée continue ; et
une étape d'ajustement de position d'arrêt d'ajustement de la quantité de mouvement (L2) de la bande porteuse ((80) qui est inférieure au pas prédéterminé (PP1) de sorte que le composant (90) soit positionné sur une position de prélèvement (PS1) du composant (90), dans laquelle l'ajustement est effectué selon la quantité de mouvement (L2) calculée à l'étape de calcul de quantité de mouvement
**caractérisé par :**
une étape de détection pour détecter une partie dentée (311) présente sur une position de détection en tant que nombre de pas du moteur (32) par un capteur de détection (50) lorsqu'une cavité (81) de plusieurs cavités (81) de bande porteuse (80) est positionnée sur une section d'avancée (211) de chargeur de bandes (20),
dans lequel la position de détection est disposée sur une position séparée par un angle dans la direction circonférentielle depuis le dessus du centre de rotation du pignon (31) dans la direction verticale.
